# EUROPEAN PATENT APPLICATION

(11) **EP 4 485 539 A1**
(43) Date of publication of application: **01.01.2025**
(21) Application number: 23181479.9
(22) Date of filing: 26.06.2023
(51) Int. Cl.: H01L 29/06, H01L 29/08, H01L 29/423, H01L 29/66, H01L 29/775, H01L 29/78, B82Y 10/00

(54) **METHOD FOR FORMING A NANOSHEET DEVICE COMPRISING A STRESSED CHANNEL REGION, AND A PRODUCT FABRICATED WITH SUCH METHOD**

(71) Applicant: IMEC VZW, 3001 Leuven (BE)
(72) Inventor: ENEMAN, Geert, 3001 Heverlee (BE); ONIKI, Yusuke, 3000 Leuven (BE); HORIGUCHI, Naoto, 3000 Leuven (BE); MORIN, Pierre, 1150 Woluwe-Saint-Pierre (BE)
(74) Representative: AWA Sweden AB

(57) **Abstract**

Provided is a method (100) for forming a nanosheet device (200), in particular a Forksheet FET, comprising a stack of nanosheets (220), the stack having a source, S, region, a drain, D, region, and a channel region (222) extending therebetween, wherein each nanosheet of the stack is stressed. The method (100) comprises depositing (10) a stress inducing dummy contact material (210) on an S/D region (224) of the stack of nanosheets (200), such that the stress inducing dummy contact material (210) transfers an associated mechanical stress to the stack of nanosheets (220), depositing (20) a gate structure material (230) on the channel region (220) subsequent to the deposition (10) of the stress inducing dummy contact material (210), removing (30) the stress inducing dummy contact material (210) subsequent to the deposition (20) of the gate structure material (230), and depositing (40) a final contact material (250) on the S/D region (224) subsequent to the removal (30) of the stress inducing dummy contact material (210). A nanosheet device (200) fabricated by the method (100) is also provided.

## Description

### TECHNICAL FIELD

The present inventive concept relates to a method for forming a nanosheet device comprising a stressed channel region, and a nanosheet device fabricated with the method.

### BACKGROUND

In the strive to provide circuit designs having ever decreasing transistor structure footprint, vertical arrangement or stacking of channel layers is presently an active research area. Example transistor structures in connection thereto are finFET, lateral nanosheet FET, and, more recently, the so-called gate-all around devices such as forksheet devices and CFET devices. Apart from the structural geometry of such transistor structures, materials, specific arrangement of individual layers, etc., may be important for achieving a desired electron mobility or reducing unwanted induced capacitances upon an electron flow being present between the source and the drain in a specific transistor. To this end, a stressed component may form part of the transistor. A stressed channel, in which electron/hole transport takes place, may thus facilitate charge transport through the transistor structure thanks to, e.g., conduction band minima splitting, change of effective mass of the charge carrier, or according to other effects originating thereof.

US20220059698A1 describes incorporation of stress in a channel region of a semiconductor transistor.

However, the present technical field calls for improved methods of forming a transistor device having stressed components.

### SUMMARY

An object of the present inventive concept is thus to provide an improved method for forming a nanosheet device having a stressed component.

Another object is to provide a simpler method for forming a nanosheet device having a stressed component.

Another object is to provide a less costly method for forming a nanosheet device having a stressed component.

Another object is to provide a faster method for forming a nanosheet device having a stressed component.

Another object is to provide a more flexible method for forming a nanosheet device having a stressed component in that the method is applicable to a number of different types of nanosheet device.

According to a first aspect of the inventive concept, there is provided a method for forming a nanosheet device comprising a stack of nanosheets, the stack comprising a source, S, region, a drain, D, region, and a channel region extending there between, wherein each nanosheet of the stack is stressed. The method comprises depositing a stress inducing dummy contact material on the S/D region of the stack of nanosheets, such that the stress inducing dummy contact material transfers an associated mechanical stress to the stack of nanosheets, depositing a gate structure material on the channel region subsequent to the deposition of the stress inducing dummy contact material, removing the stress inducing dummy contact material subsequent to the deposition of the gate structure material, and depositing a final contact material on the S/D region subsequent to the removal of the stress inducing dummy contact material.

The present approach facilitates dissociating the function of a stressor in the S/D cavity from the S/D region/contact. That is, the stress inducing dummy contact material may be optimized for mechanical purposes.

Further, increasing a total cumulative mechanical stress induced into the channel region may be facilitated upon the deposition of the final contact material in the S/D region. This is further elaborated on below.

The method may in principle be applicable to any type of nanosheet devices, such as a finFET device, a CFET device, a forksheet device, or the like. Any of these transistor types may function according to having one or more channels in which electrons/holes may move upon applying a bias voltage over the channel region, i.e., between the source region and the drain region, controlled by a gate potential. The electron or hole flow is thus further tuned or turned on/off by changing an electric potential at a gate structure located between the source and the drain region.

The region at which the gate structure is arranged is thus henceforth referred to as "channel region" or "active region".

The "stack of nanosheets" may refer to a stack comprising one or more nanosheets.

According to the above, "the S/D region" may refer to either or both of the source region and the drain region of the nanosheet device. Although the method may refer to that stress is transferred from the stress inducing dummy contact material being present in the source region to the channel region, the skilled person readily appreciates that the opposite may additionally or alternatively be possible, i.e., that stress may be transferred from the stress inducing dummy contact material being present in the drain region to the channel region.

The mechanical stress transferred by the stress inducing dummy contact material typically originates from deposition of the stress inducing dummy contact material onto the S/D region.

The mechanical stress may alternatively or additionally originate from thermal expansion due to different coefficient of thermal expansion, CTE, between the stress inducing dummy contact material and the first portion of the channel. The magnitude of the generated stress may depend on thermal mismatch and on the Youngs' modulus of the stressor, i.e., the stress inducing dummy contact material.

Another possibility is an intrinsic stress being present in the stress inducing dummy contact material which may depend on the material structure at different length scales, e.g., inter or intra grain in a polycrystal, atomic bond coordination, bonding length/strength, lattice mismatch, as engineered during deposition etc. This category includes physical and chemical mechanisms occurring either during growth or in post treatment.

Upon the channel region being stressed by the stress inducing dummy contact material, mechanical stress may be transferred directly or indirectly to contacting materials. The amount of mechanical stress depends on the geometry of the full structure, the stiffness properties of the directly or indirectly contacting materials, etc. Herein, the stress inducing contact material and the channel region are in so-called serial mode in that they are substantially aligned along a longitudinal axis, i.e., along the channel region in which charge transport takes place. The situation is qualitatively comparable to two springs connected in series wherein one of the springs, the stress inducing dummy contact material, is initially strained whereas the remaining spring (the channel) is unbiased. After the release of the first spring, both the first and the second spring become stressed.

The disclosed method provides a particularly efficient transfer of mechanical stress into the channel region. Thus, the replacement of the stress inducing dummy contact material with the final contact material facilitates maintaining, i.e., "locking", the stress in the channel region which thus benefits from improved electronic characteristics thereof (further described below). That is, the deposition of the gate structure material may lock the stress in the channel region transferred by the stress inducing dummy contact material, and substantially maintain the stress in the channel region also after removal of the stress inducing dummy contact material. Further, the deposition of the final contact material may increase the stress in the channel region even further. The stressed channel region may thus benefit from higher conductance compared to a corresponding non-stressed channel, thereby facilitating electron/hole transport in the channel without requirement of modification of the footprint or modification of other structural features of the transistor structure. The final contact material has traditionally been focused on a compromise between low electrical resistance (relating to the work function of the material) and stress. The present approach, however, overcomes this compromise as the material of the final contact material is directed towards its electrical properties. Hence, the presented approach facilitates tuning of the mechanical stress to achieve a desirable resistance/conductance of the channel(s). Furthermore, the stress inducing dummy contact material and the final contact material may be separately optimized in that the stress inducing dummy contact material may be optimized for high channel region stress whereas the final contact material may be optimized for low contact resistance.

Spatial terms such as "longitudinal" and "vertical", as used herein, are to be understood in relation to a substrate on which the nanosheet device is to be placed or fabricated on, wherein "longitudinal" denotes an orientation or direction parallel to a main plane of extension of the substrate and "vertical" denotes an orientation or direction normal to the main plane of extension of the substrate. Throughout, the term "longitudinal" refers to an extension of the channel region in which charge transport is to take place if not stated otherwise. Correspondingly, relative spatial terms such as, "upper", "lower", "top", "bottom", "above", "under", "underneath", "below", are to be understood in relation to the substrate, as seen along the vertical/normal direction.

The terms "frontside" and "backside" of a substrate refer respectively to the two mutually opposite (main) sides of the substrate, wherein the frontside is the side of the substrate on which the nanosheet device (and any further active devices) are located or formed, and the backside is the opposite side of the substrate.

The term "source/drain", S/D, as occasionally used herein is to be understood as a source or a drain. Hence, "source/drain region" may either be a source region or a drain region.

Hence, the S/D region may correspond to either or both, of the source region and the drain region depending on a present context.

Preferably, provided the nanosheet device is of n-FET type, the stress inducing dummy contact material transfers a tensile longitudinal stress to the channel region.

Conventionally, and also herein, it is to be understood that it is the source/drain epitaxy being subject to the above n-FET feature, and normally not the channel region of the nanosheets themselves, which preferably are undoped.

Preferably, the stress inducing dummy contact material is formed by a material comprising one or more of W, Si₃N₄, SiO₂, Si, and SiC.

These materials are particularly advantageous for mechanically locking the mechanical stress.

Preferably, the stress inducing dummy contact material is formed by any one of the previously mentioned materials in events the nanosheet device being of n-FET type.

Preferably, provided the nanosheet device is of p-FET type, the stress inducing dummy contact material transfers a compressive longitudinal stress to the channel region.

Preferably, the stress inducing dummy contact material is formed by a material comprising one or more of SiN, SiGe and a metal.

SiN, epitaxial SiGe having a relatively high Ge concentration, and the metal deposited using a highly compressive deposition technique are particularly advantageous for functioning as a stress inducing material.

Preferably, the stress inducing dummy contact material is formed by any one of the previously mentioned materials in events the nanosheet device being of p-FET type.

Preferably, the stress inducing dummy contact material is one or more of a material having an intrinsic internal stress, a material obtaining an internal stress while being subjected to one or more of heating and cooling, and a material transferring a stress when deposited on the S/D region.

The options of these variants and their advantages have been discussed above.

Preferably, the stress inducing dummy contact material transfers a maximum stress level in a range defined by 100-3000 MPa, wherein a major component of the stress is along the channel. By maximum stress level it is meant the maximum level of stress transferred to the channel region. The stress level will thus decay and become lower at points of the channel region being different to that of a point of the maximum stress level.

Preferably, an electrical conductance of the final contact material is higher than an electrical conductance of the stress inducing dummy contact material.

According to the above, this embodiment facilitates reduction of electrical resistance. The final contact material may however also facilitate reduction of the Schottky barrier present between the contacting materials, i.e., between the final contact material and the material in direct connection thereto. The Schottky barrier may thus be viewed as a contact resistance, or so-called parasitic resistance. Hence, also in this respect, increased electron/hole mobility may be facilitated in the nanosheet device.

Preferably, the final contact material is a stress inducing final contact material, such that the final contact material transfers an associated further mechanical stress to the channel region.

This may further increase electron/hole mobility in the channel region.

Preferably, the stress inducing dummy contact material and the stress inducing final contact material transfers a respective tensile mechanical stress to the channel region. Alternatively, the stress inducing dummy contact material and the stress inducing final contact material transfers a respective compressive mechanical stress to the channel region.

Hence, both the (temporary) stress inducing dummy contact material and the final contact material may transfer the same type of stress, which may further increase a final stress in the channel region and thus facilitate electron/hole mobility in the channel region.

Preferably, the method further comprises depositing a first intermediate layer between the S/D region and the channel region, prior to depositing the stress inducing dummy contact material.

The first intermediate layer may function as a gate spacer layer, typically sandwiching the gate structure provided, as is typically the case, the nanosheet device is longitudinally symmetric on longitudinally opposing sides of the gate structure. The gate spacer layer determines the channel region length, the junction geometry, and the electronic band structure profile between the gate structure and the channel region. Preferably, the gate spacer layer may be made of a material being any one of SiN, SiCON or SiCO. However, other materials having similar physical/chemical properties may be suitable.

Preferably, the method further comprises depositing a second intermediate layer arranged between the S/D region and the channel region.

The second intermediate layer may form part of the gate structure and may face the first intermediate layer, i.e., the spacer layer. The second intermediate layer may determine, affect, or alter the work function of the gate structure. This may be achieved by, e.g., using a a TiN layer.

Preferably, the nanosheet device is any one of a gate-all-around, GAA, device, a finFET device, a planar FET device, and a forksheet device.

The method may thus be applicable to several types of transistor types, thus being a flexible and general methodology for facilitating electron/hole mobility in different types of transistor structures.

According to a second aspect of the inventive concept, there is provided a nanosheet device fabricated by the method according to the first aspect.

The above-mentioned features in connection to the first aspect apply also to the second aspect. To avoid undue repetition, reference is made to the above where applicable.

A further scope of applicability of the present invention will become apparent from the detailed description given below. However, it should be understood that the detailed description and specific examples, while indicating preferred embodiments of the inventive concept, are given by way of illustration only, since various changes and modifications within the scope of the inventive concept will become apparent to those skilled in the art from this detailed description.

Hence, it is to be understood that the present inventive concept is not limited to the particular component parts of the device described or acts of the methods described as such device and method may vary. It is also to be understood that the terminology used herein is for the purpose of describing particular embodiments only and is not intended to be limiting. It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several units, and the like. Furthermore, the words "comprising", "including", "containing" and similar wordings do not exclude other elements or steps.

### BRIEF DESCRIPTION OF THE DRAWINGS

The above, as well as additional objects, features, and advantages of the present inventive concept, will be better understood through the following illustrative and non-limiting detailed description, with reference to the appended drawings, in the drawings like reference numerals will be used for like elements unless stated otherwise.
Fig. 1 shows a flowchart of a method for forming a nanosheet device having a stressed channel region according to the embodiments of the first inventive aspect.
Figs 2A-B schematically and pictorially show two different cross-sectional perspective views of manufacturing steps of a method for forming a nanosheet device having a stressed channel region according to embodiments of the first inventive aspect.

### DETAILED DESCRIPTION

The present inventive concept will now be described more fully hereinafter with reference to the accompanying drawings, in which currently preferred variants of the inventive concept are shown. This inventive concept may, however, be embodied in many different forms and should not be construed as limited to the embodiments set forth herein; rather, these embodiments are provided for thoroughness and completeness, and to fully convey the scope of the inventive concept to the skilled person.

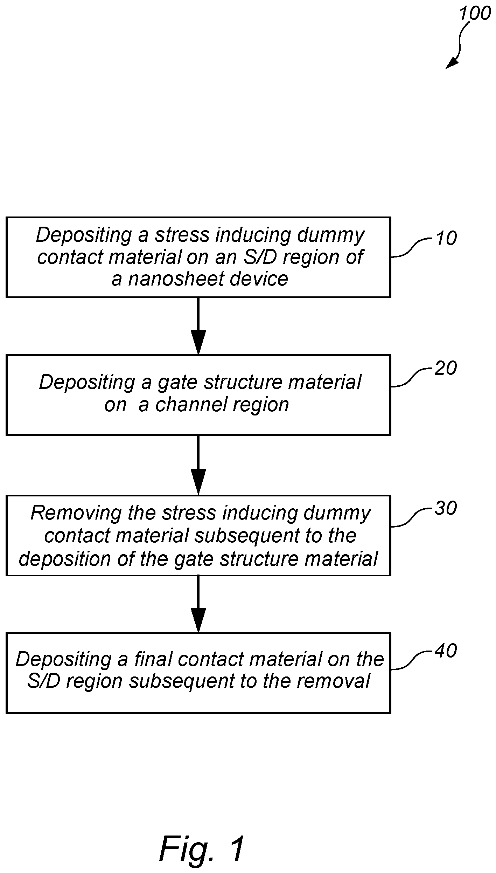

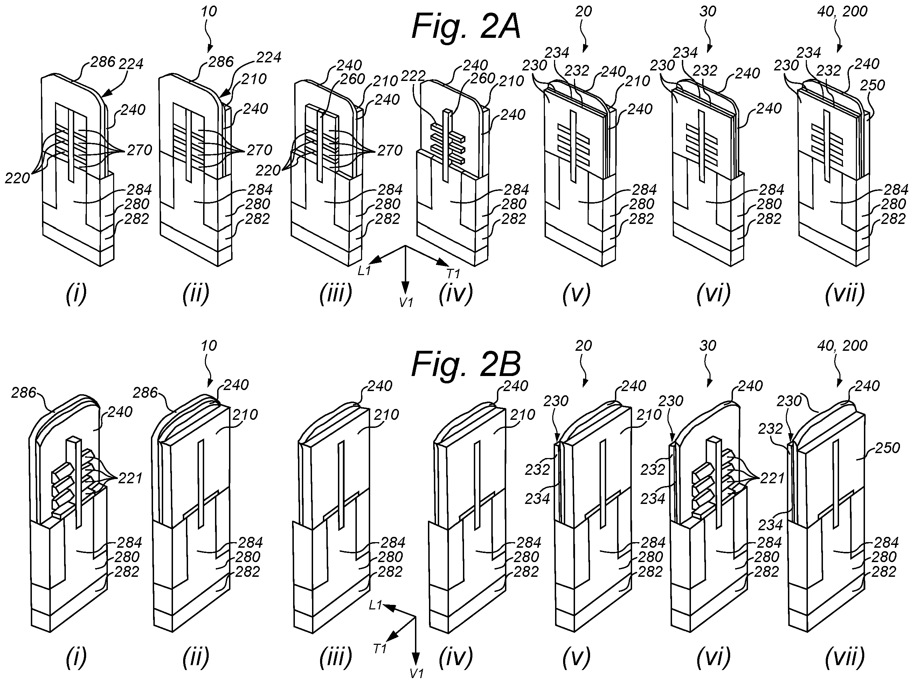

Figs 1 and 2 may be viewed interchangeably/in parallel while reading the detailed description of preferred variants below.

Fig. 1 shows a flowchart of a method 100 for forming a nanosheet device 200 having a stressed channel region 222.

Figs 2A-B schematically and pictorially show manufacturing steps in a method 100 for forming a nanosheet device 200 having a stressed channel region 222. More specifically, Figs 2A-B schematically and stepwise illustrate a cross-sectional view of a nanosheet device 200 being formed. References to structural features are thus shown in Figs 2A-B, where Fig. 2B clarifies, e.g., a schematic epi layer 221 of a source/drain region, manifestly being obscured in Fig. 2A. In order to increase the illegibility, method steps 10, 20, 30, and 40 of method 100 are indicated in Fig. 2. Reference numerals herein are placed where relevant parts/components are best viewed as of the layered structure of the nanosheet device 200. Further, a coordinate system of the perspective view of the nanosheet device 200 is spanned/defined by a longitudinal extension L1, a transverse extension T1, and a vertical extension V1. Spatial relationships and references may thus utilize this terminology below.

The nanosheet device 200 is herein displayed as a slice of the full nanosheet device 200 in that only a relatively small longitudinally extending portion of the nanosheet device in vicinity of a gate structure 230 is shown. Hence, it is to be understood that only a portion of the channel region 222 and the S/D region is depicted, and that the channel region 222 extends further on a distal and proximal side of the shown nanosheet device 200. Further, it is appreciated that the channel region 222 refers to a region where any gate structure (dummy gate or final metal gate) is located. Further, the skilled person realizes that the substantially right angles depicted throughout in Fig. 2 are artificial from a practical point of view. In a real nanoscale fabrication process, these angles are in general smooth and rounded, and thus difficult to control exactly.

The channel region 222 may be viewed as an ordinary depletion region/zone in which the amount of charge carriers is controlled by a voltage/potential of a gate structure arranged in its vicinity.

The nanosheet device 200 as exemplified herein is a so-called forksheet device 200, referring to a device comprising a first 220 and a second set of vertically stacked channel layers (nanosheets) formed on opposite sides of a vertically oriented dielectric wall 260. Each channel layer of the first set of vertically stacked channel layers have an inner edge contacting a first side of the dielectric wall 260 and each channel layer of the second set of vertically stacked channel layers have an inner edge contacting a second side of the dielectric wall 260, opposite the first side. The forksheet device 200 comprises a first gate stack surrounding the first set of vertically stacked channel layers and contacting the first side of the dielectric wall 260, and a second gate stack surrounding the second set of vertically stacked channel layers and contacting the second side of the dielectric wall 260. The first transistor may comprise an N-type gate stack and the second transistor may comprise a P-type gate stack, or vice versa, where it is, per the above, understood that the P-/N-type feature refers to the epi layers in connection with respective gate stack. The term "channel" as used in connection with the forksheet device 200 typically refers to all the vertically stacked channel layers of a specific type.

The method 100 may however be applied to other types of transistor structures, such as finFET devices, horizontal or lateral (stacked) nanosheet FET devices, complementary FET devices, nanowire transistor devices, planar transistor devices, forksheet-based devices, etc. The skilled person is thus expected to easily appreciate the method 100, and thus exercising the inventive concept upon considering these other types of transistor structures.

Hence, generally, the claimed nanosheet device 200 comprises a stack of nanosheets 220, the stack comprising a source region, a drain region, and a channel region 222 extending therebetween, wherein each nanosheet of the stack 220 is stressed. In the above and below presented examples of the nanosheet device 200 being a forksheet device, the stack of nanosheets 220 may refer to the stack of nanosheets present on either side (or both sides) of the dielectric wall 260, as readily appreciated by those skilled in the art.

The method 100 comprises depositing 10 a stress inducing dummy contact material 210 on the S/D region 224 of the stack of nanosheets 220, such that the stress inducing dummy contact material transfers an associated mechanical stress to the stack of nanosheets 220. Suitable methods of depositing 10 the inducing dummy contact material 210 typically include state of the art deposition methods. Such deposition methods may include conformal and non-conformal deposition methods. In Fig. 2A, being a schematic perspective view of a slice representing a longitudinal portion of the nanosheet device 200, the S/D region 224 is located on a distal side of the view. The S/D region 224 may be either a source region or a drain region. Below it is assumed, in a non-limiting way, that the S/D region is located at the same side as the source region. The deposited stress inducing dummy contact material 210 may, after deposition, be in direct contact with the channel and/or an epi layer 221 of the concerned source/drain region. The epi layer 221 is schematically depicted in Fig. 2B (i) and (vi). The epi layer(s), or source/drain layer(s), may, e.g., be made of Si or SiGe or any other material as known for a person skilled in the art.

The stress inducing dummy contact material 210 may be one or more of a material having an intrinsic internal stress, a material transferring an internal stress while being subjected to one or more of heating and cooling, and a material transferring a stress when deposited on the S/D region. Examples in these regards may be as follows. The mechanical stress transferred by the stress inducing dummy contact material 210 may originate from deposition of the stress inducing dummy contact material 210 onto the S/D region 224. The mechanical stress may alternatively or additionally originate from thermal expansion due to different coefficient of thermal expansion, CTE, between the stress inducing dummy contact material and the S/D region. The magnitude of the generated stress may depend on thermal mismatch and on the Young's modulus of the stressor, i.e., the stress inducing dummy contact material. However, such thermally induced stress is in general comparatively small.

Another possibility is intrinsic stress of the stress inducing dummy contact material 210 depending on the material structure at different scales, e.g., inter or intra grain in a polycrystal, atomic bond coordination, bonding length/strength, lattice mismatch etc. This category includes physical and chemical mechanisms occurring either during growth or in post treatment. Upon the channel region 222 being strained by the stress inducing dummy contact material 210, mechanical stress is transferred to directly or indirectly to contacting materials, e.g., one or more channels regions 222 of the nanosheet device 200. The amount of mechanical stress may depend on the geometry of the full structure, the stiffness properties of the directly or indirectly contacting materials, etc. Herein, the stressor 210 and the channel region 222 are in so-called serial mode in that they are aligned along a longitudinal axis (along the channel region 222).

The method 100 further comprises depositing 20 a gate structure material 230 on the channel region 222 subsequent to the deposition 10 of the stress inducing dummy contact material 210. Suitable methods for depositing 20 a gate structure material 230 typically include state of the art deposition methods. Such deposition methods may include conformal and non-conformal deposition methods, chemical vapor deposition, CVD, and/or atomic layer deposition, ALD. The gate structure material 230 may comprise a plurality of layers arranged along the longitudinal extension L1. By way of example herein, the gate structure material 230 may comprise a first gate structure layer 232 and a second gate structure layer 234 where one of the gate structure layers carries the work function of the gate structure. The first gate structure layer 232 may comprise a metal such as W, and the second gate structure layer 234 may comprise TiN. The second gate structure layer 234 may also be referred to as the second intermediate layer 234 herein. Other gate structure materials may however be possible, as appreciated by the skilled person.

The method 100 further comprises removing 30 the stress inducing dummy contact material 210 subsequent to the deposition 20 of the gate structure material 230. Removal of the stress inducing dummy contact material 210 may be done with etching or other adequate techniques. Such etching may include isotropic etching and/or anisotropic etching.

The method 100 further comprises depositing 40 a final contact material 250 on the S/D region 224 subsequent to the removal 30 of the stress inducing dummy contact material 210. Suitable methods of depositing 40 the final contact material 250 include state of the art deposition methods. Such deposition methods may include conformal and non-conformal deposition methods.

The S/D region 224 may correspond to either or both of the source region and the drain region.

A couple of (possibly conventional) prerequisites regarding the manufacturing method 100 and structural features in connection with the nanosheet device 200 follow below.

Prior to depositing the stress inducing dummy contact material 210, , a dummy gate structure 286 may be deposited. The dummy gate structure 286 is hence afterwards replaced with the gate structure material 230 according to, e.g., a known replacement metal gate, RMG, technique.

The nanosheet device 200 may be formed/deposited on a conventional substrate 282 made of, e.g., Si, the substrate 282 forming a bottom wafer-like substrate structure on which the nanosheet device 200 is arranged. Manifestly, a large number of essentially equivalent nanosheet devices 100 are arranged on the same substrate 282. The channel region 222, i.e., in this example, a set of vertically arranged channel regions 222 may be vertically elevated relative to the substrate 282 by a protruding structure 284 having a width along the transverse extension T1 being similar to a width of the channel (or, as exemplified herein, the total width of two channels plus their intermediate vertically oriented dielectric wall 260). The protruding structure 284 is advantageously made of the same material as the substrate 282, i.e., Si. To separate/insulate adjacent nanosheet devices 200 along the transverse extension T1, a shallow trench isolation, STI, structure 280 may be formed/deposited by a conventional STI procedure. The STI structure 280 may prevent electric current leakage between adjacent nanosheet devices 200.

In events of a stack of nanosheets 220 being present in the nanosheet device 200 as of Fig. 2, the nanosheets may be mutually separated by sacrificial layers 270 made of, e.g., SiGe. The sacrificial layers 270 are removed prior to the deposition of the gate structure material 230 to release the nanosheets, i.e., between the method steps 10 and 20.

Signal and power routing may be arranged to the nanosheet device 200 in a conventional manner.

Now returning to the present method 100. In the event the nanosheet device 200 being of n-FET type, the stress inducing dummy contact material 210 has material properties for transferring a tensile stress to the channel region 222. In the present example of the forksheet device shown in Figs 2A-B, one of the sides of the vertically oriented dielectric wall 260 may be of n-FET type, whereas a transversely opposing side of the vertically oriented dielectric wall 260 may be of p-FET type. For the side being of n-FET type, the stress inducing dummy contact material 210 may be formed by a material comprising one or more of W, a W comprising material, Si₃N₄, SiO₂, and Si.

In the event of the nanosheet device 200 being of p-FET type, , the stress inducing dummy contact material 210 has material properties for transferring a compressive stress to the channel region 222. In the present example of Fig. 2, this applies to the side of the vertically oriented dielectric wall 260 being a p-FET type nanosheet device. Hence, for a forksheet device, the stress inducing dummy contact material 210 may comprise two types of materials; one for each side of the vertically oriented dielectric wall 260. This is to account for the tensile/compressive transfer of mechanical stress into the channel region 222. For the p-FET type nanosheet device the stress inducing dummy contact material 210 may be formed by a material comprising any one of SiN, SiGe and a metal. SiN, epitaxial SiGe having a relatively high Ge concentration and a metal deposited using a highly compressive deposition technique epitaxial SiGe having a high Ge concentration and a metal deposited using a highly compressive deposition technique are particularly advantageous for functioning as a stress inducing material.

The stress inducing dummy contact material 210 may be one or more of a material having an intrinsic internal stress, a material obtaining an internal stress while being subjected to one or more of heating and cooling, and a material transferring a stress when deposited on the S/D region 224.

The stress inducing dummy contact material 210 may transfer a maximum stress level in a range defined by 100-3000 MPa, wherein a major component of the stress is along the channel region 222. Per the above, along the channel region 222 refers to a longitudinal extension L1 of the channel region 222. However, significant components of the stress may also be present along the vertical V1 and transverse T1 extension of the channel region 222.

An electrical conductance of the final contact material 250 may be higher than an electrical conductance of the stress inducing dummy contact material 210.

The final contact material 250 may be a stress inducing final contact material 250, such that the final contact material 250 transfers an associated further mechanical stress to the channel region 222. The final contact material 250 may thus share stress related properties with the stress inducing dummy contact material 210. Reference to such stress related properties is made to the above.

The stress inducing dummy contact material 210 and the stress inducing final contact material 250 may transfer a respective tensile mechanical stress to the channel region 222. Alternatively, where applicable, the stress inducing dummy contact material 210 and the stress inducing final contact material 250 transfers a respective compressive mechanical stress to the channel region 222. Again, by reference to the presently exemplified forksheet device, the tensile or compressive mechanical stress to be transferred depends on the doping type of respective side of the dielectric wall 260, i.e., p-FET type or n-FET type.

The method 100 may further comprise depositing a first intermediate layer 240 between the S/D region 224 and the channel region 222, prior to depositing the stress inducing dummy contact material 210. The first intermediate layer may be a spacer layer 240. A similar spacer layer 240 may be deposited/present on a longitudinally opposing side of the gate structure 230. The spacer layer 240 may be made of a nitride compound such as Si₃N₄, or the like.

The method 100 may further comprise depositing a second intermediate layer 234 arranged between the S/D region 224 and the channel region 222. The second intermediate layer 234 may form part of the gate structure 234. The second intermediate layer 234 may be responsible for the work function of the gate structure 230 in the sense that it affects the work function of the gate structure 230. The second intermediate layer 234 may be made of TiN, or any other material/alloy being capable to fulfil a similar purpose.

As partly set out above, the nanosheet device may be one of a gate-all-around, GAA, device, a finFET device, a nanowire device, a nanotube device, a planar FET device, and a forksheet-based device.

The inventive concept further refers to a transistor device 200 fabricated by the method 100.

Accordingly, and in summary, in some variants discussed above, there has been described a method 100 for forming a nanosheet device 200 having a stressed channel region 222, wherein the channel region 222 is stressed according to the method steps 10, 20, 30, and 40. The method 100 facilitates a particularly simple and efficient way of generating a stress in the channel region 220, and thus facilitates charge transport through the nanosheet device 200 while affection of the physical structure of the nanosheet device is held minimal.

The person skilled in the art realizes that the present inventive concept by no means is limited to the preferred embodiments described above. On the contrary, many modifications and variations are possible within the scope of the appended claims. Variations to the disclosed embodiments can be understood and effected by the skilled person in practicing the claimed invention, from a study of the drawings, the disclosure, and the appended claims.

## Claims

1. A method (100) for forming a nanosheet device (200) comprising a stack of nanosheets (220), the stack comprising a source, S, region, a drain, D, region, and a channel region (222) extending therebetween, wherein each nanosheet of the stack is stressed, the method (100) comprising:
depositing (10) a stress inducing dummy contact material (210) on the S/D region (224) of the stack of nanosheets (220), such that the stress inducing dummy contact material (210) transfers an associated mechanical stress to the stack of nanosheets (220),
depositing (20) a gate structure material (230) on the channel region (222) subsequent to the deposition (10) of the stress inducing dummy contact material (210),
removing (30) the stress inducing dummy contact material (210) subsequent to the deposition (20) of the gate structure material (230), and
depositing (40) a final contact material (250) on the S/D region (224) subsequent to the removal (30) of the stress inducing dummy contact material (210).

2. The method (100) according to claim 1, wherein the S/D region (224) corresponds to either or both of the source region and the drain region.

3. The method (100) according to claim 1 or 2, wherein the stress inducing dummy contact material (210) transfers a tensile longitudinal stress to the channel region (222), and wherein the nanosheet device is of n-FET type.

4. The method (100) according to claim 3, wherein the stress inducing dummy contact material (210) is formed by a material comprising one or more of W, a W comprising material, Si₃N₄, SiO₂, and Si.

5. The method (100) according to claim 1, wherein the stress inducing dummy contact material (210) transfers a compressive stress to the channel region (222), and wherein the nanosheet device is of p-FET type.

6. The method (100) according to claim 5, wherein the stress inducing dummy contact material (210) is formed by a material comprising one or more of SiN, SiGe and a metal.

7. The method (100) according to any one of claims 1-6, wherein the stress inducing dummy contact material (210) is one or more of a material having an intrinsic internal stress, a material obtaining an internal stress while being subjected to one or more of heating and cooling, and a material transferring a stress when deposited on the S/D region (224).

8. The method (100) according to any one of claims 1-7, wherein the stress inducing dummy contact material (210) transfers a maximum stress level in a range defined by 100-3000 MPa, wherein a major component of the stress is along the channel region (222).

9. The method (100) according to any one of claims 1-8, wherein an electrical conductance of the final contact material (250) is higher than an electrical conductance of the stress inducing dummy contact material (210).

10. The method (100) according to any one of claims 1-9, wherein the final contact material (250) is a stress inducing final contact material (250), such that the final contact material (250) transfers an associated further mechanical stress to the channel region (222).

11. The method (100) according to claim 10, wherein the stress inducing dummy contact material (210) and the stress inducing final contact material (250) transfers a respective tensile mechanical stress to the channel region (222), or wherein the stress inducing dummy contact material (210) and the stress inducing final contact material (250) transfers a respective compressive mechanical stress to the channel region (222).

12. The method (100) according to any one of claims 1-11, wherein the method (100) further comprises depositing a first intermediate layer (240) between the S/D region (224) and the channel region (222), prior to depositing (10) the stress inducing dummy contact material (210).

13. The method (100) according to claim any one of claims 1-12, the method (100) further comprising depositing a second intermediate layer (234) arranged between the S/D region (224) and the channel region (222).

14. The method (100) according to any one of claims 1-13, wherein the nanosheet device (200) is any one of a gate-all-around, GAA, device, a finFET device, a planar FET device, and a forksheet device (200).

15. A nanosheet device (200) fabricated by the method (100) according to any one of claims 1-14.
